# EUROPÄISCHE PATENTSCHRIFT

(11) **EP 1 068 644 B1**
(45) Veröffentlichungstag und Bekanntmachung des Hinweises auf die Patenterteilung: **08.07.2015**
(21) Anmeldenummer: 99914440.5
(22) Anmeldetag: 17.03.1999
(51) Int. Cl.: H01L 27/112, H01L 27/115, H01L 21/8246, G11C 16/06

(54) **SPEICHERZELLENANORDNUNG UND VERFAHREN ZU IHRER HERSTELLUNG**
MEMORY CELL ARRANGEMENT AND METHOD FOR PRODUCING THE SAME
ENSEMBLE DE CELLULES MEMOIRES ET SON PROCEDE DE REALISATION

(30) Priorität: 24.03.1998 DE 19812948
(43) Veröffentlichungstag der Anmeldung: 17.01.2001
(73) Patentinhaber: Infineon Technologies AG, 85579 Neubiberg (DE)
(72) Erfinder: REISINGER, Hans, D-82031 Grünwald (DE)
(74) Vertreter: Zimmermann & Partner Patentanwälte mbB
(86) Internationale Anmeldenummer: PCT/DE1999/000762
(87) Internationale Veröffentlichungsnummer: WO 1999/049516

(56) Entgegenhaltungen:
- WO-A-96/33513
- US-A- 5 306 941

## Beschreibung

Die Erfindung betrifft eine Speicherzellenanordnung, bei der im Bereich einer Hauptfläche eines Halbleitersubstrats mehrere Speicherzellen vorhanden sind, bei der die Speicherzellen jeweils wenigstens einen MOS-Transistor mit Source, Gate und Drain enthalten, bei der die Speicherzellen in im wesentlichen parallel verlaufenden Speicherzellenzeilen angeordnet sind, bei der benachbarte Speicherzellenzeilen durch einen Isolationsgraben isoliert sind, bei der benachbarte Speicherzellenzeilen jeweils wenigstens eine Bitleitung enthalten und wobei die Bitleitungen zweier benachbarter Speicherzellenzeilen einander zugewandt sind.

Die Erfindung betrifft ferner ein Verfahren zur Herstellung dieser Speicherzellenanordnung.

Speicherzellen werden in weiten Technologiegebieten eingesetzt. Bei den Speicherzellen kann es sich sowohl um Festwertspeicher handeln, die als ROM (Read Only Memory) bezeichnet werden, als auch um programmierbare Speicher, die als PROM (Programmable ROM) bezeichnet werden.

Speicherzellenanordnungen auf Halbleitersubstraten zeichnen sich dadurch aus, daß sie einen wahlfreien Zugriff auf die in ihnen gespeicherte Information erlauben. Sie enthalten eine Vielzahl von Transistoren. Beim Lesevorgang werden dem Vorhandensein oder dem Nichtvorhandensein eines Stromflusses durch den Transistor die logischen Zustände 1 oder 0 zugeordnet. Üblicherweise wird die Speicherung der Information dadurch bewirkt, daß MOS-Transistoren eingesetzt werden, deren Kanalgebiete eine der gewünschten Sperreigenschaft entsprechende Dotierung aufweisen.

Eine gattungsgemäße Speicherzellenanordnung ist in der US-PS 5 306 941 dargestellt. Bei dieser Speicherzellenanordnung sind im Randbereich von Speicherzellenstegen Bitleitungen angeordnet, wobei die Bitleitungen benachbarter Speicherzellenstege einander zugewandt sind. Die Bitleitungen sind dabei jeweils durch einen mit einem isolierenden Material gefüllten Isolationsgraben voneinander getrennt. Dieses Dokument offenbart ferner ein Verfahren zur Herstellung einer Speicherzellenanordnung, bei dem Speicherzellenstege dadurch gebildet werden, daß in ein Halbleitersubstrat Isolationsgräben geätzt werden. Nach dem Ätzen der Isolationsgräben erfolgt eine Diffusion eines Dotierstoffs, wobei durch die Diffusion Bitleitungen gebildet werden. So wird ein Halbleiterspeicher mit einer Vielzahl von Speicherzellen geschaffen, die am Boden der Gräben und auf den Stegen zwischen den Gräben gebildet sind. Diese gattungsgemäße Speicherzellenanordnung eignet sich für Strukturgrößen von mindestens 0,5 µm und für einen ROM-Festwertspeicher. Eine elektrische Programmierung ist hierbei nicht möglich.

Eine weitere Speicherzellenanordnung ist aus der DE-OS 195 10 042 bekannt. Diese Speicherzellenanordnung enthält in Zeilen angeordnete MOS-Transistoren. In jeder Zeile sind die MOS-Transistoren in Reihe geschaltet. Zur Erhöhung der Speicherdichte sind benachbarte Zeilen jeweils abwechselnd am Boden von streifenförmigen Längsgräben und zwischen benachbarten streifenförmigen Längsgräben an der Oberfläche des Substrats angeordnet. Miteinander verbundene Source/Drain-Gebiete sind als zusammenhängendes dotiertes Gebiet ausgebildet. Durch ein zeilenweises Ansteuern ist es möglich, diese Speicherzellenanordnung auszulesen.

Diese Speicherzellenanordnung zeichnet sich dadurch aus, daß der für die Speicherzellen erforderliche Flächenbedarf von 4 F² auf 2 F² verringert wurde, wobei F die minimale Strukturbreite des für die Herstellung eingesetzten photolitographischen Prozesses ist. Nachteilig ist jedoch, daß eine weitere Erhöhung der Anzahl der Speicherzellen je Flächeneinheit hierbei nicht möglich ist.

Der Erfindung liegt die Aufgabe zugrunde, die Nachteile des Standes der Technik zu überwinden. Insbesondere soll eine Speicherzellenanordnung geschaffen werden, bei der eine möglichst große Anzahl von Speicherzellen auf möglichst kleinem Raum angeordnet ist. Vorzugsweise soll die Speicherzellenanordnung auch elektrisch programmierbar sein.

Diese Aufgabe wird bei einer gattungsgemäßen Vorrichtung dadurch gelöst, daß der Isolationsgraben tiefer in das Halbleitersubstrat eindringt als die Bitleitungen und daß sich unterhalb des Isolationsgrabens wenigstens ein Teilbereich der Source oder der Drain befindet.

Die Erfindung sieht also vor, die Speicherzellenanordnung so zu gestalten, daß sie Speicherzellenstege enthält, zwischen denen sich Isolationsgräben befinden, die tief in das Halbleitersubstrat eindringen und so eine wirksame Isolation von einander gegenüberliegenden Bitleitungen ermöglichen.

Eine elektrische Verbindung zwischen den Sources oder den Drains von verschiedenen Speicherzellenstegen erfolgt vorzugsweise dadurch, daß sich ein Teilbereich der Sources oder der Drains von einem Speicherzellensteg zu einem weiteren Speicherzellensteg erstreckt.

Vorzugsweise liegen hierbei die Sources oder Drains verschiedener Transistoren in einer gemeinsamen Wanne.

Durch Vorsehen eines Gatedielektrikums mit Haftstellen für elektrische Ladungsträger, zum Beispiel einer Dreifachschicht mit einer ersten SiO₂-Schicht, einer Si₃N₄-Schicht und einer zweiten SiO₂-Schicht, oder ähnliches wird die Speicherzellenanordnung elektrisch programmierbar.

Die Erfindung betrifft ferner ein Verfahren zur Herstellung einer Speicherzellenanordnung, bei dem in ein Halbleitersubstrat Isolationsgräben geätzt werden, so daß sich zwischen den Isolationsgräben Stege herausbilden und bei dem anschließend Bitleitungen erzeugt werden. Dieses Verfahren wird erfindungsgemäß so durchgeführt, daß vor dem Erzeugen der Bitleitungen Kanalgebiete erzeugt werden und daß nach dem Erzeugen der Bitleitungen ein weiterer Ätzschritt erfolgt, durch den die Isolationsgräben tiefer in das Halbleitersubstrat eindringen.

Weitere Vorteile, Besonderheiten und zweckmäßige Weiterbildungen der Erfindung ergeben sich aus der nachfolgenden Darstellung bevorzugter Ausführungsbeispiele anhand der Zeichnungen.

Von den Zeichnungen zeigt
- Figur 1: einen Querschnitt durch ein Halbleitersubstrat nach einem ersten Ätzvorgang,
- Figur 2: das in Figur 1 dargestellte Halbleitersubstrat nach Implantation eines ersten Dotierstoffs,
- Figur 3: das Halbleitersubstrat nach Implantation eines zweiten Dotierstoffs,
- Figur 4: das Halbleitersubstrat nach einem weiteren Ätzvorgang,
- Figur 5: ein Schaltbild für einen elektrischen Anschluß einzelner Bereiche des in Figur 4 dargestellten Halbleitersubstrats,
- Figur 6: einen Ausschnitt aus einem Schnitt senkrecht zu dem in Figur 1 bis 4 gezeigten Schnitt durch den oberen Bereich des Halbleitersubstrats nach Abscheiden einer dielektrischen Schicht, Abscheidung und Strukturierung einer Halbleiterschicht und dem Abscheiden eines weiteren isolierenden Materials,
- Figur 7: den Ausschnitt aus dem oberen Bereich des Halbleitersubstrats nach Durchführung einer anisotropen Ätzung zur Bildung von Abstandsstücken,
- Figur 8: den Ausschnitt aus dem oberen Bereich des Halbleitersubstrats nach einem weiteren Ätzvorgang,
- Figur 9: den Ausschnitt aus dem oberen Bereich des Halbleitersubstrats nach Aufwachsen einer dielektrischen Schicht,
- Figur 10: den Ausschnitt aus dem oberen Bereich des Halbleitersubstrats nach Aufbringen und teilweisem Wegätzen einer Elektrodenschicht,
- Figur 11: eine Aufsicht auf die fertige Speicherzellenanordnung,
- Figur 12: das elektrische Schaltbild eines Ausschnitts aus dem Zellenfeld.

Auf ein Halbleitersubstrat 10 aus zum Beispiel n-dotiertem monokristallinen Silizium mit einer Grunddotierstoffkonzentration von vorzugsweise 1 x 10¹⁶ cm⁻³ bis 1 x 10¹⁷ cm⁻³, beispielsweise 2 x 10¹⁶ cm⁻³ wird eine Maske 15 aufgetragen. Die Maske 15 kann beispielsweise aus nach einem TEOS (Si(OC₂H₅)₄)-Verfahren gebildeten Siliziumoxid bestehen. Bei einem TEOS-Verfahren wird Tetraethylorthosilikat Si(OC₂H₅)₄ bei einer Temperatur von ungefähr 700 Grad Celsius und einem Druck im Bereich von 40 Pa in Siliziumoxid SiO₂ umgewandelt.

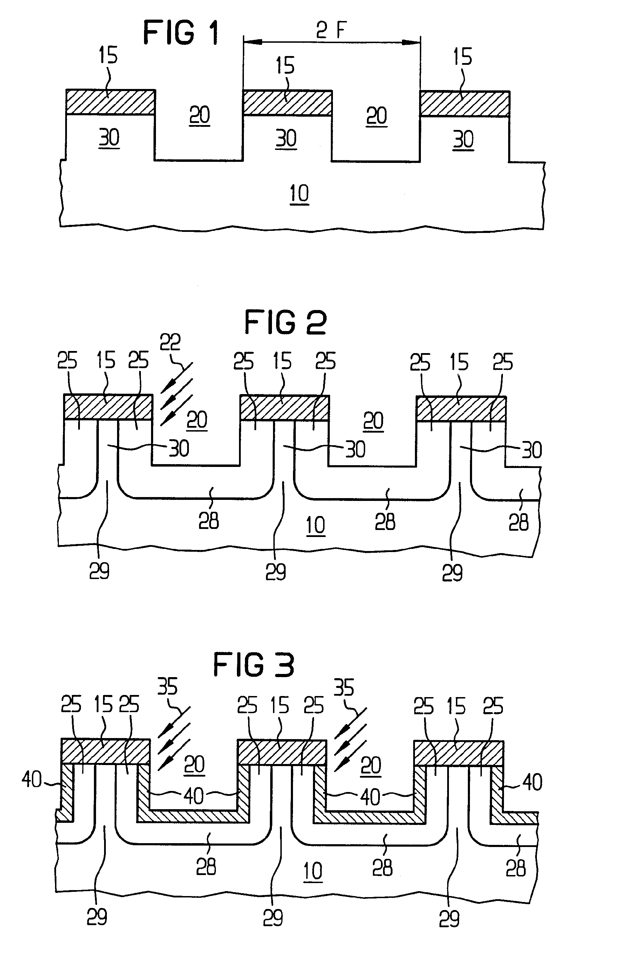

Nach dem Auftragen der Maske 15 wird ein Ätzprozeß, beispielsweise mehrstufig mit einem ersten Ätzschritt mit einem Gasgemisch aus CF₄ und O₂ oder CHF₃ und O₂ und einem zweiten Ätzschritt mit einem HBr-haltigen Gas durchgeführt, so daß sich in dem Halbleitersubstrat 10 Isolationsgräben 20 bilden. Zwischen den Isolationsgräben 20 befinden sich Stege 30, wobei der Abstand der Mitten benachbarter Stege 30 2F beträgt. Hierbei ist F die minimal herstellbare Strukturgröße, vorzugsweise im Bereich von 0,1 µm bis 0,5 µm. Dieser Bearbeitungszustand des Halbleitersubstrats ist in Figur 1 dargestellt.

Anschließend erfolgt eine Implantation eines ersten Dotierstoffs 22, so daß Seitenbereiche 25 der Stege 30 und untere Bodenbereiche 28 der Isolationsgräben 20 p-dotiert sind. Die Seitenbereiche 25 der Stege 30 und die Bodenbereiche 28 der Isolationsgräben 20 bilden in der fertigen Speicherzellenanordnung Kanalgebiete. Zur Erzeugung einer p-Dotierung wird beispielsweise Bor bei einer Implantationsenergie, die vorzugsweise in der Größenordnung von 10 bis 20 keV liegt, implantiert. Die Implantationsdosis ist gleich dem Produkt aus einer gewünschten Konzentration und der Dicke einer zu dotierenden Schicht und beträgt beispielsweise bei einer bevorzugten Schichtdicke von etwa 0,2 µm und einer vorteilhaften Konzentration von 2 x 10¹⁷ cm⁻³ 4 x 10¹² cm⁻². Nach der Implantation und einem Eintreiben beträgt die Konzentration des Dotierstoffs in den Seitenbereichen 25 und in den unteren Bodenbereichen 28 ungefähr 2 x 10¹⁷ cm⁻³. Durch das Eintreiben des Dotierstoffs bildet ein Bodenbereich 28 mit zwei mit ihm verbundenen Seitenbereichen 25 einen Bereich, in dem sich in der fertigen Speicherzellenanordnung ein durchgehender Kanal bilden kann. Dieser Bearbeitungszustand des Halbleitersubstrats ist in Figur 2 dargestellt.

Anschließend erfolgt eine Implantation eines weiteren Dotierstoffs 35, so daß Seitenwände 40 der Stege 30 und obere Bodenbereiche 50 der Isolationsgräben 20 vom entgegengesetzten Leitfähigkeitstyp wie die Seitenbereiche 25 und der Bodenbereich 28 hochdotiert sind. Zur Erzeugung einer n⁺-Dotierung wird beispielsweise Phosphor oder Arsen bei einer Implantationsenergie, die vorzugsweise in der Größenordnung von 40 bis 80 keV liegt, und mit einer Dosis im Bereich um 2 x 10¹⁵ cm⁻² implantiert. Nach dieser Implantation beträgt die Konzentration des Dotierstoffs in den Seitenwänden 40 und in den oberen Bodenbereichen 50 ungefähr 2 x 10²⁰ cm⁻³. Dieser Bearbeitungszustand des Halbleitersubstrats ist in Figur 3 dargestellt.

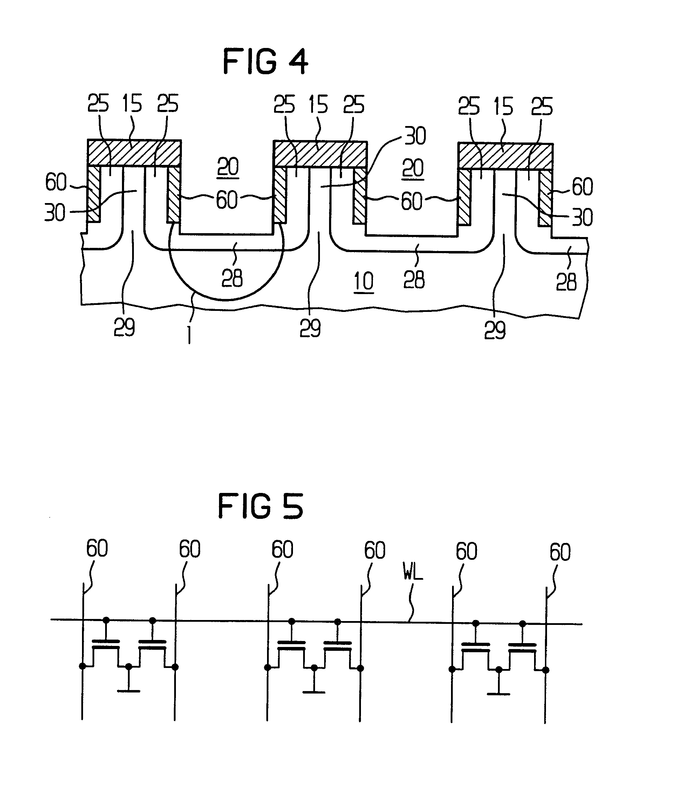

Zur Isolation zwischen den einzelnen Stegen 30 erfolgt anschließend ein weiterer Ätzprozeß. Hierdurch werden die Isolationsgräben 20 tiefer geätzt und die dotierten oberen Bodenbereiche 50 der Isolationsgräben 20 entfernt. Durch diesen Prozeß bilden sich aus den Seitenwänden 40 der Stege 30 räumlich voneinander getrennte Bitleitungen 60, deren gegenseitige Isolation dadurch sichergestellt wird, daß die Isolationsgräben 20 möglichst weit in das Substrat eindringen. Teile der Bitleitungen 60 bilden in der fertigen Speicherzellenanordnung Drains von MOS-Transistoren. Die Bitleitungen 60 weisen eine Höhe von ungefähr 200 nm auf. Die Tiefe der Isolationsgräben 20 ist größer als die Höhe der Bitleitungen 60. Hierdurch wird eine wirksame Weglänge 1 für einen möglichen Strompfad durch das Halbleitersubstrat 10 vergrößert. Dieser Bearbeitungszustand des Halbleitersubstrats ist in Figur 4 dargestellt.

Eine niederohmige Verbindung zwischen den Sources 29 erfolgt beispielsweise über eine gemeinsame, nicht eingezeichnete Wanne. Eine Verbindung kann beispielsweise auch über das Halbleitersubstrat oder eine elektrisch leitende Schicht erfolgen.

Die Breite der Bitleitungen 60 beträgt ungefähr 50 nm. Bei einer Querschnittsfläche von 200 10⁻⁹ m x 50 10⁻⁹ m = 1 x 10⁻¹⁴ m² ergibt sich ein Widerstand der Bitleitungen in der Größenordnung von wenigen 100 kΩ je mm Länge der Bitleitung, wobei ein typischer Wert 500 kΩ/mm beträgt. Hierdurch sind Zellenfelder von etwa 1 mm Kantenlänge realisierbar.

Eine typische Einsatzspannung einer derartigen Speicherzellenanordnung beträgt ungefähr 0,6 V. Ein Schaltbild für einen elektrischen Anschluß der Bitleitungen 60 und von Wortleitungen WL ist in Figur 5 dargestellt.

Durch einen nicht dargestellten Silizidierungsprozeß kann der Widerstand der Bitleitungen 60 wesentlich gesenkt werden, vorzugsweise um einen Faktor 10 oder mehr. Bei einem derartigen Silizidierungsprozeß werden die Bitleitungen 60 in ein geeignetes Silizid, d.h. in eine Metall-Siliziumverbindung umgewandelt. In dem vorliegenden Fall ist es besonders zweckmäßig, Silizide wie MoSi₂, WSi₂, TaSi₂, TiSi₂, PtSi, Pd₂Si durch Silizierung herzustellen. Bei einer Silizierung handelt es sich um eine selektive Silizidbildung. Sie erfolgt vorzugsweise dadurch, daß das silizidbildende Metall allein aufgesputtert wird und anschließend mit den Bitleitungen als Siliziumunterlage zu einer Silizidreaktion gebracht wird. Nach dem Aufbringen des silizidbildenden Metalls erfolgt eine Temperung bei Temperaturen im Bereich von 600 bis 1000 °C, wodurch es zur Bildung des Metallsilizids kommt.

Anschließend wird die Maske 15 entfernt. Nach dem Entfernen der Maske 15 werden die Isolationsgräben 20 mit einem isolierenden Material gefüllt, beispielsweise mit in einem TEOS-Verfahren gebildeten SiO₂. Dies kann dadurch erfolgen, daß Tetraethylorthosilikat: Si(OC₂H₅)₄ bei einer Temperatur von ungefähr 700 °C und einem Druck im Bereich von 40 Pa in Siliziumoxid SiO₂ umgewandelt wird.

Nach dem Füllen der Isolationsgräben 20 mit dem isolierenden Material erfolgt ein Planarisierungsvorgang, vorzugsweise ein Prozeß des chemisch-mechanischen Planarisierens. Danach wird eine geeignete dielektrische Schicht auf die Stege 30 und die Isolationsgräben 20 aufgebracht. Die dielektrische Schicht kann vorzugsweise durch eine Mehrfachschicht gebildet werden. Besonders zweckmäßig ist es, wenn die dielektrische Schicht eine Dreifachschicht ist, mit einer ersten dielektrischen Schicht 90 aus Siliziumoxid SiO₂ in einer Dicke von ungefähr 3 nm, einer mittleren dielektrische Schicht 100 aus Siliziumnitrid von ungefähr 7 bis 8 nm Dicke und einer oberen dielektrischen Schicht 110 aus Siliziumoxid mit einer Dicke von etwa 4 nm.

Die erste dielektrische Schicht 90 wird zum Beispiel durch eine Temperung in einer O₂-haltigen Atmosphäre in einer gewünschten Schichtdicke gebildet. Hierbei wird das Silizium der Stege 30 in Siliziumoxid SiO₂ umgewandelt. Anschließend kann diese Schicht durch anisotropes Ätzen beispielsweise mit CHF₃ strukturiert werden.

Die zweite dielektrische Schicht 100 wird vorzugsweise nach einem CVD (Chemical Vapour Deposition)-Verfahren aufgebracht, insbesondere nach einem LPCVD (Low Pressure CVD)-Verfahren. Eine besonders geeignete Variante zur Bildung der zweiten dielektrischen Schicht 100 nach dem LPCVD-Verfahren kann dadurch erfolgen, daß Dichlorsilan (SiH₂CL₂) unter Zugabe von Ammoniak (NH₃) bei einer Temperatur im Bereich von etwa 750 °C in einem Plasma bei einem Druck zwischen 10 Pa und 100 Pa, bevorzugt 30 Pa, in Siliziumnitrid (Si₃N₄) umgewandelt wird.

Anschließend wird die obere dielektrische Schicht 110 durch thermische Oxidation, vorzugsweise in einer H₂O-haltigen Atmosphäre bei einer Temperatur um 900 °C und einem Zeitraum von etwa 2 Stunden oder nach einem der bekannten Schichterzeugungsverfahren, zum Beispiel einem HTO-Verfahren, abgeschieden. Eine Abscheidung mit einem HTO-Verfahren kann vorzugsweise dadurch geschehen, daß Dichlorsilan SiH₂Cl₂ in einer N₂O-haltigen Atmosphäre bei einer Temperatur von ungefähr 900 °C und einem Druck im Bereich von 40 Pa in Siliziumoxid SiO₂ umgewandelt wird.

Auf die obere dielektrische Schicht 110 wird eine Halbleiterschicht 120, beispielsweise aus hochdotiertem polykristallinen Silizium aufgewachsen. Eine bevorzugte Dotierung des polykristallinen Siliziums beträgt wenigstens 10²⁰ cm⁻³, wobei Dotierungen ab 10²¹ cm⁻³ besonders geeignet sind.

Beispielsweise ist die Halbleiterschicht 120 durch eine Diffusion oder Implantation von Phosphor oder Arsen n⁺-dotiert. Eine Implantation kann beispielsweise mit einer Energie von 80 keV und einer Dosis von 1 x 10¹⁶ cm⁻² erfolgen.

Anschließend wird eine Lackmaske auf die Halbleiterschicht 120 aufgetragen. Danach folgt ein Ätzprozeß, beispielsweise mehrstufig mit einem ersten Ätzschritt mit einem Gasgemisch aus CF₄ und O₂ oder CHF₃ und O₂ und einem zweiten Ätzschritt mit einem HBr-haltigen Gas. Hierdurch werden Isolationsgräben 130 in die Halbleiterschicht 120 geätzt. Zwischen den Isolationsgräben 130 entstehen durch das übriggebliebene Material der Halbleiterschicht 120 Stege 140, die in der fertiggestellten Speicherzellenanordnung als Wortleitungen dienen.

Anschließend wird auf die Stege 140 und die Isolationsgräben 130 eine Isolationsschicht 150 nach einem geeigneten, möglichst konformen Verfahren abgeschieden. Es ist besonders zweckmäßig, die Isolationsschicht 150 nach einem TEOS-Verfahren zu bilden. Dies kann dadurch erfolgen, daß Tetraethylorthosilikat Si(OC₂H₅)₄ bei einer Temperatur von ungefähr 700 °C und einem Druck im Bereich von 40 Pa in Siliziumoxid SiO₂ umgewandelt wird.

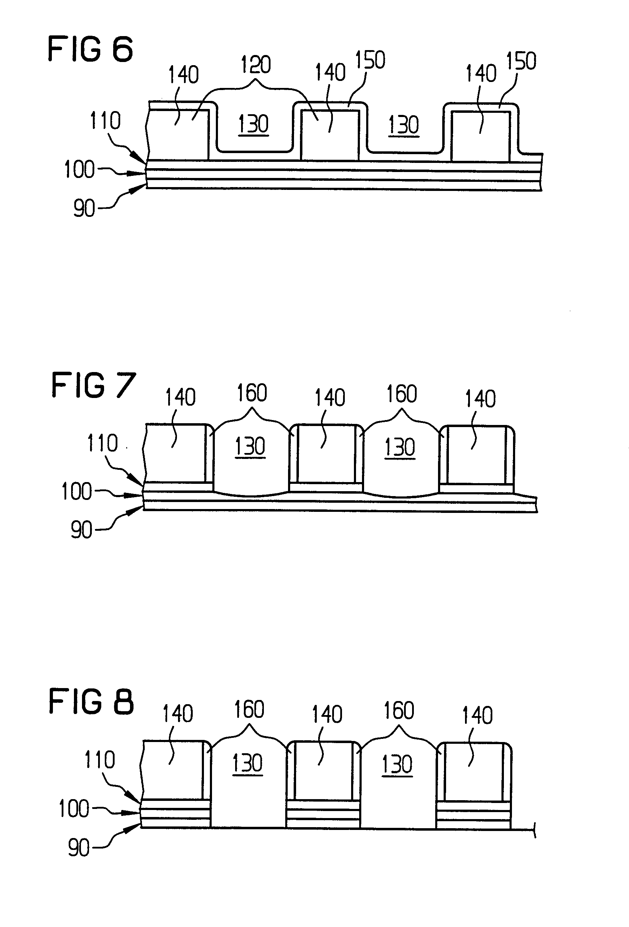

Der Ausschnitt des Halbleitersubstrats, in dem sich die dielektrischen Schichten 90, 100 und 110 sowie die Stege 140 befinden, ist in Figur 6 dargestellt. Figur 6 zeigt dabei einen Schnitt, der senkrecht zu dem in Figur 1 bis 4 gezeigten Schnitt durch einen der Stege 30 verläuft.

Anschließend erfolgt eine anisotrope Ätzung der Isolationsschicht 150, wobei der Ätzabtrag dieses Ätzvorganges der Dikke der Isolationsschicht 150 auf ebenen Gebieten entspricht. An den Seitenwänden der Stege 140 bleiben daher Abstandsstükke 160 stehen, die auch als TEOS-Spacer bezeichnet werden. Dieser Zustand des Halbleitersubstrats ist in Figur 7 dargestellt.

Anschließend erfolgt ein Ätzprozeß, wobei die nitridhaltige dielektrische Schicht 100 durch die Anwendung eines geeigneten Mittels, beispielsweise von Phosphorsäure mit einer Konzentration im Bereich von 80 % und einer Temperatur um 150°C entfernt wird. Der mehrstufige Ätzprozeß stoppt auf der oxidhaltigen unteren dielektrischen Schicht 90. Die dünne dielektrische Schicht 90 wird in dem Bereich der Isolationsgräben 130 durch einen weiteren Ätzvorgang, beispielsweise mit einer flußsäurehaltigen Lösung (HF-dip), entfernt. Dieser Zustand des Halbleitersubstrats ist in Figur 8 dargestellt.

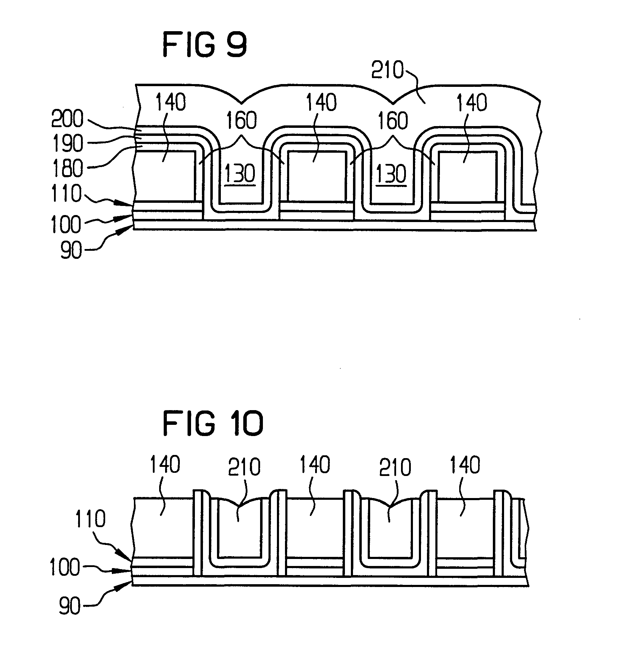

Anschließend wird eine neue Dreifachschicht aufgewachsen. Dazu werden eine untere dielektrische Schicht 180, eine mittlere dielektrische Schicht 190 und eine obere dielektrische Schicht 200 gebildet. Vorzugsweise besteht die untere dielektrische Schicht 180 aus Siliziumoxid SiO₂, das zum Beispiel in einem Temperverfahren in einer gewünschten Schichtdicke gebildet wird. Hierbei wird im Oberflächenbereich der Stege 140 und des Halbleitermaterials 120 Silizium in einer sauerstoffhaltigen Atmosphäre bei einer Temperatur von ungefähr 800 bis 900 °C in Siliziumoxid SiO₂ umgewandelt. Die mittlere dielektrische Schicht 190 wird vorzugsweise durch eine Nitridschicht, die durch ein LPCVD-Verfahren bei ungefähr 700 °C erzeugt wurde, gebildet. Die oberste dielektrische Schicht 200 besteht vorzugsweise aus dem gleichen Material wie die untere dielektrische Schicht 180, also wiederum bevorzugt aus SiO₂. Die Dicke der unteren dielektrischen Schicht 180 beträgt im Endzustand beispielsweise 3 nm, die Dicke der mittleren dielektrischen Schicht 190 ungefähr 7 bis 8 nm und die Dicke der oberen dielektrischen Schicht 200 4 nm. Eine derartige Abfolge der Dicken der Schichten ist besonders zweckmäßig, um eingefangene Ladungen möglichst lange zu speichern. Dieser Zustand des Halbleitersubstrats ist in Figur 9 dargestellt.

Anschließend wird ganzflächig eine Elektrodenschicht 210 gebildet. Die Elektrodenschicht 210 besteht beispielsweise aus einem dotierten Halbleitermaterial, bevorzugt n-dotiertem polykristallinen Silizium, Metallsilizid und/oder einem Metall.

Das Halbleitermaterial der Elektrodenschicht 210 kann jedoch auch p-dotiert sein.

Die Elektrodenschicht 210 wird in einer Dicke gebildet, die ausreicht, die Isolationsgräben 130 zwischen den die Wortleitung bildenden Stegen 140 zu füllen. Die Elektrodenschicht 210 wird deshalb in einer Dicke von ungefähr 0,2 µm bis 0,6 µm, bevorzugt 0,4 µm, abgeschieden.

Anschließend wird die Elektrodenschicht 210 strukturiert. Die Strukturierung der Elektrodenschicht 210 erfolgt in einem mehrschrittigen Verfahren. Zunächst wird die Elektrodenschicht 210 durch einen Planarisierungsprozeß, beispielsweise einen CMP (chemisch-mechanisches Planarisieren) - Schritt entfernt. Hierbei wirkt die mittlere dielektrische Schicht 190 als Stoppschicht.

Anschließend wird oberhalb der Stege die dielektrische Schicht 170 durch das Entfernen ihrer Teilschichten 180, 190 und 200 entfernt. Danach erfolgt ein weiteres Rückätzen oder ein Prozeß des chemisch-mechanischen Planarisierens (CMP) (Figur 10).

In der Speicherzellenanordnung werden Speicherzellen durch MOS-Transistoren realisiert, die jeweils aus einem Teil einer der Bitleitungen 60, der als Drain wirkt, des daran angrenzenden Seitenbereichs 25, der als Kanalgebiet wirkt, einer der Sources 29 sowie der dielektrischen Schicht 90, 100, 110, die als Gatedielektrikum wirkt, und einem der Stege 140, der als Gateelektrode wirkt, bzw. die Dreifachschicht 180, 190, 200, die als Gatedielektrikum wirkt, und einem Teil der strukturierten Elektrodenschicht 210, die als Gateelektrode wirkt, gebildet werden.

Da die Stege 140 und die strukturierte Elektrodenschicht 210 selbstjustiert zueinander hergestellt werden, ist die Speicherzellenanordnung mit einem Abstand der Mitten von entlang einem der Stege 30 benachbarten Gateelektroden von einer minimal herstellbaren Strukturgröße F herstellbar. Der Abstand der Mitten benachbarter Stege 30 beträgt bei Verwendung einer Maske 15, die mit Hilfe photolithographischer Prozeßschritte hergestellt wird, minimal 2F. Da die Stege 30 senkrecht zum Verlauf der Bitleitungen 60 jeweils zwei benachbarte Speicherzellen aufweisen, beträgt der Platzbedarf pro Speicherzelle F².

Wird die Maske 15 mit Hilfe einer Spacertechnik gebildet, so wird ein Abstand der Mitten benachbarter Stege 30 von F erreicht. Damit ergibt sich ein Platzbedarf pro Speicherzelle von 0,5 x F².

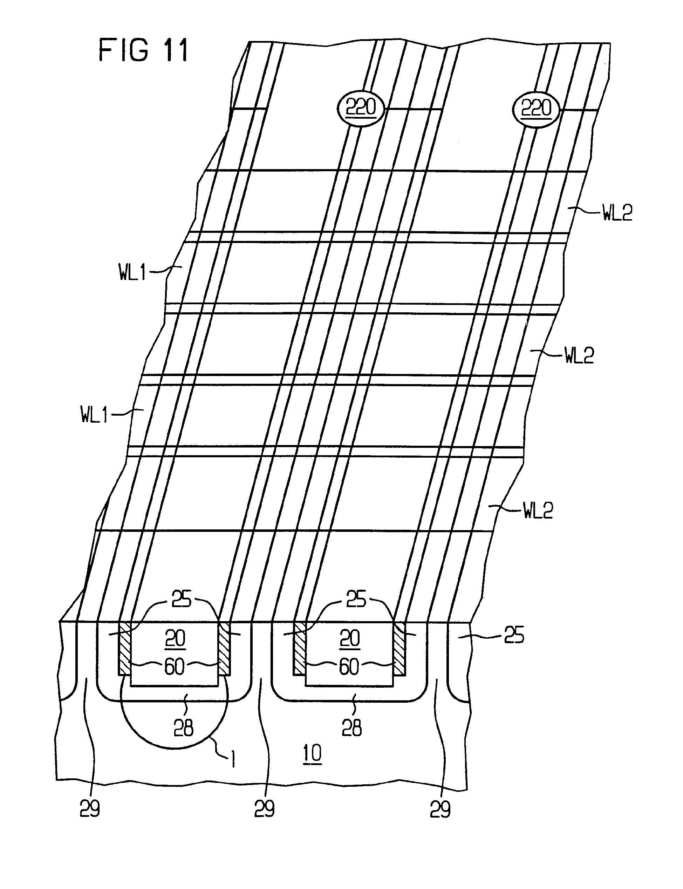

Eine Aufsicht auf die fertige Speicherzellenanordnung ist in Figur 11 dargestellt. Bei dieser Darstellung ist die Anordnung der Bitleitungen 60 sowie von ersten Wortleitungen WL 1 und zweiten Wortleitungen WL 2 sichtbar. Die ersten Wortleitungen WL1 und die zweiten Wortleitungen WL 2 werden durch die Stege 140 beziehungsweise durch die strukturierte Elektrodenschicht 210 gebildet, wobei jedoch die Strukturen 90, 100, 110, 130, 140, 160, 180, 190 und 210 nicht dargestellt sind.

Hierbei ist zu erkennen, daß von den beiden an einem Steg 30 anliegenden Bitleitungen 60 jeweils eine Bitleitung 60 im oberen Bereich des Zellenfeldes mit einem Kontakt 220 verbunden ist. Die jeweils andere Bitleitung 60 des Steges 30 ist auf eine nicht dargestellte Weise mit dem unteren Rand des Zellenfeldes verbunden.

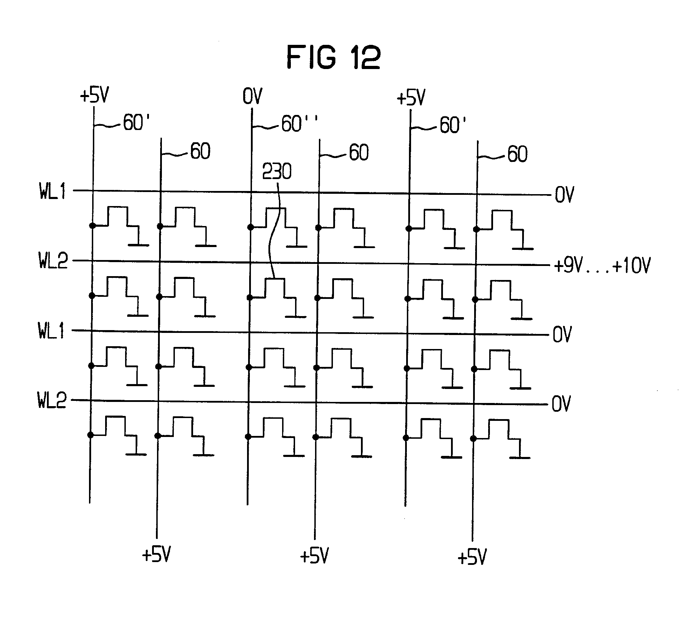

In Figur 12 ist das elektrische Schaltbild eines Ausschnitts aus dem Zellenfeld dargestellt.

Hierbei ist eine Verschaltung zwischen den Bitleitungen 60, 60', 60" und Wortleitungen WL 1 und WL 2 erkennbar.

Zur Verdeutlichung der Funktionsweise der elektrischen Schaltung sind beispielhaft jene Spannungen dargestellt, die erforderlich sind, um eine Speicherzelle 230 zu beschreiben.

Ein Beschreiben der Speicherzelle 230 erfolgt durch das Tunneln von elektrischer Ladung. An der Speicherzelle 230 liegt über die zugehörige Wortleitung WL 2 eine Gatespannung von vorzugsweise 9 V bis 10 V an. Die gemeinsamen Sources aller Speicherzellen liegen auf einem gemeinsamen, erhöhten Potential von beispielsweise 5 V. Über die Bitleitung 60" liegt an der Speicherzelle 230 eine Drainspannung von 0 V an. An den anderen Zellen liegt entweder eine Gatespannung 0 oder eine positive Drainspannung von beispielsweise 5 V an. Hierdurch wird ein Löschen von bereits beschriebenen Zellen vermieden.

Ein Lesen einer Speicherzelle erfolgt vorzugsweise so, daß die gemeinsamen Sources der Speicherzellen auf 0 V liegen, daß die zu der Zelle gehörende Bitleitung sich auf einem positiven Potential befindet und daß die zu der Zelle gehörende Wortleitung sich auf einem Potential von beispielsweise 3 V befindet.

Ein gleichzeitiges Löschen aller Speicherzellen erfolgt vorzugsweise dadurch, daß die gemeinsamen Sources der Zellen auf 0 V liegen, daß alle Bitleitungen 60, 60', 60" auf dem Potential 0 V liegen und daß über die Wortleitungen WL 1 und WL 2 eine negative Gatespannung von beispielsweise -10 V anliegt.

Die Erfindung ist nicht auf die beschriebenen Ausführungsbeispiele beschränkt. Insbesondere können die n- und p-Dotierungen vertauscht sein.

## Patentansprüche

1. Speicherzellenanordnung,
- bei der im Bereich einer Hauptfläche eines Halbleitersubstrats (10) Stege (30) angeordnet sind, zwischen denen jeweils ein Isolationsgraben (20) mit einander gegenüberliegenden Seitenwänden angeordnet ist, wobei die Stege (30) mehrere Speicherzellen (230) aufweisen, die in im wesentlichen parallel verlaufende Speicherzellenzeilen angeordnet sind;
- bei der die Speicherzellen (230) jeweils wenigstens einen MOS-Transistor mit Source (29), Gate und Drain enthalten;
- bei der benachbarte Speicherzellenzeilen benachbarter Stege (30) durch einen Isolationsgraben (20) isoliert sind;
- bei der benachbarte Speicherzellenzeilen jeweils wenigstens eine Bitleitung (60, 60', 60") enthalten, die jeweils an eine der Seitenwände der Stege (30) angrenzt, so daß die Bitleitungen (60, 60', 60") zweier benachbarter Speicherzellenzeilen, zwischen denen ein Isolationsgraben (20) angeordnet ist, einander zugewandt sind;
**dadurch gekennzeichnet,**
**daß** der Isolationsgraben (20) tiefer in das Halbleitersubstrat (10) eindringt als die Bitleitungen (60, 60', 60") und daß sich unterhalb des Isolationsgrabens (20) wenigstens ein Teilbereich der Source (29) oder der Drain befindet.

2. Speicherzellenanordnung, nach Anspruch 1,
**dadurch gekennzeichnet,**
**daß** die Sources (29) oder die Drains benachbarter MOS-Transistoren als zusammenhängend dotiertes Gebiet ausgebildet sind.

3. Speicherzellenanordnung, nach einem der Ansprüche 1 oder 2,
**dadurch gekennzeichnet,**
**daß** der Isolationsgraben (20) 0,1 µm bis 0,5 µm tiefer in das Halbleitersubstrat (10) eindringt als die Bitleitungen (60,60',60").

4. Speicherzellenanordnung, nach einem der Ansprüche 1 bis 3,
**dadurch gekennzeichnet,**
**daß** die Bitleitungen (60, 60', 60") eine Höhe von 0,1 µm bis 0,3 µm aufweisen.

5. Speicherzellenanordnung nach einem der Ansprüche 1 bis 4,
- bei der der Steg (30) jeweils zwei Speicherzellenzeilen aufweist, und
- bei der senkrecht zum Verlauf der Bitleitungen (60) benachbarte Speicherzellen eine gemeinsame Source (29) oder Drain aufweisen.

6. Verfahren zur Herstellung einer Speicherzellenanordnung, bei dem in ein Halbleitersubstrat (10) Isolationsgräben (20) geätzt werden, so daß sich zwischen den Isolationsgräben (20) Stege (30) herausbilden, und bei dem anschließend Bitleitungen (60, 60', 60") erzeugt werden,
**dadurch gekennzeichnet,**
**daß** vor dem Erzeugen der Bitleitungen (60, 60', 60'') Kanalgebiete erzeugt werden, und daß nach dem Erzeugen der Bitleitungen (60, 60', 60") ein weiterer Ätzschritt erfolgt, durch den die Isolationsgräben (20) tiefer in das Halbleitersubstrat (10) eindringen.

7. Verfahren nach Anspruch 6,
**dadurch gekennzeichnet,**
**daß** die Bitleitungen (60, 60', 60") durch Implantation von Ionen (35) erzeugt werden.

8. Verfahren nach einem der Ansprüche 6 oder 7,
**dadurch gekennzeichnet,**
**daß** die Bitleitungen (60, 60', 60") in eine Metallverbindung umgewandelt werden.

9. Verfahren nach Anspruch 8,
**dadurch gekennzeichnet,**
**daß** die Bitleitungen (60, 60', 60") in eine Metall-Siliziumverbindung umgewandelt werden.

## Claims

1. Memory cell arrangement
- in which bars (30) are arranged in the region of a main area of a semiconductor substrate (10), between which bars (30) in each case an isolation trench (20) with mutually opposite side walls is arranged,
wherein the bars (30)have a plurality of memory cells (230) which are arranged in memory cell rows which run essentially parallel;
- in which the memory cells (230) each contain at least one MOS transistor having a source (29), gate and drain;
- in which adjacent memory cell rows of adjacent bars (30) are insulated by an isolation trench (20);
- in which adjacent memory cell rows each contain at least one bit line (60, 60', 60") which in each case adjoins one of the side walls of the bars (30), such that the bit lines (60, 60', 60") of two adjacent memory cell rows between which an isolation trench (20) is arranged face one another;
**characterized in that** the isolation trench (20) penetrates more deeply into the semiconductor substrate (10) than the bit lines (60, 60', 60"), and **in that** at least one partial region of the source (29) or of the drain is situated below the isolation trench (20).

2. Memory cell arrangement according to Claim 1, **characterized in that** the sources (29) or the drains of adjacent MOS transistors are designed as a contiguously doped region.

3. Memory cell arrangement according to either of Claims 1 and 2, **characterized in that** the isolation trench (20) penetrates from 0.1 µm to 0.5 µm more deeply into the semiconductor substrate (10) than the bit lines (60, 60', 60").

4. Memory cell arrangement according to one of Claims 1 to 3, **characterized in that** the bit lines (60, 60', 60'') have a height of from 0.1 µm to 0.3 µm.

5. Memory cell arrangement according to one of Claims 1 to 4,
- in which the bar (30) has in each case two memory cell rows, and
- in which adjacent memory cells perpendicular to the course of the bit lines (60) have a common source (29) or drain.

6. Method for fabricating a memory cell arrangement, in which isolation trenches (20) are etched into a semiconductor substrate (10), bars (30) thereby being formed between the isolation trenches (20), and in which bit lines (60, 60', 60") are subsequently produced,
**characterized in that** channel regions are produced before the bit lines (60, 60', 60") are produced, and **in that** a further etching step is performed after the bit lines (60, 60', 60") have been produced, as a result of which etching step the isolation trenches (20) penetrate more deeply into the semiconductor substrate (10).

7. Method according to Claim 6, **characterized in that** the bit lines (60, 60', 60") are produced by implantation of ions (35).

8. Method according to either of Claims 6 and 7, **characterized in that** the bit lines (60, 60', 60") are converted into a metal compound.

9. Method according to Claim 8, **characterized in that** the bit lines (60, 60', 60'') are converted into a metal-silicon compound.

## Revendications

1. Agencement de cellules de mémoire,
- dans lequel il est disposé, dans la zone d'une surface principale d'un substrat (10) semiconducteur, des nervures (30), entre lesquelles est disposé respectivement un sillon (20) isolant ayant des parois latérales opposées, les nervures (30) ayant plusieurs cellules (230) de mémoire, qui sont disposées en des lignes de cellules de mémoire s'étendant sensiblement parallèlement ;
- dans lequel les cellules (230) de mémoire comportent respectivement au moins un transistor MOS ayant une source (29), une grille et un drain ;
- dans lequel des lignes de cellules de mémoire voisines de nervures (30) voisines sont isolées par des sillons (20) isolants ;
- dans lequel des lignes de cellules de mémoire voisines comportent respectivement au moins une ligne (60, 60', 60") de bit, qui est voisine respectivement de l'une des parois latérales des nervures (30), de sorte que les lignes (60, 60', 60") de bit de deux lignes de cellules de mémoire voisines, entre lesquelles est disposé un sillon (20) isolant, soient tournées l'une vers l'autre ;
**caractérisé**
**en ce que** le sillon (20) isolant pénètre plus profondément dans le substrat (10) semiconducteur que les lignes (60, 60', 60") de bit et en ce qu'au moins une zone partielle de la source (29) ou du drain se trouve en dessous du sillon (20) isolant.

2. Agencement de cellules de mémoire suivant la revendication 1,
**caractérisé**
**en ce que** les sources (29) ou les drains de transistors MOS voisins sont constitués sous la forme d'une région dopée d'un seul tenant.

3. Agencement de cellules de mémoire suivant la revendication 1 ou 2,
**caractérisé**
**en ce que** le sillon (20) isolant pénètre plus profondément de 0,1 µm à 0,5 µm dans le substrat (10) semiconducteur que les lignes (60, 60', 60") de bit.

4. Agencement de cellules de mémoire suivant l'une des revendications 1 à 3,
**caractérisé**
**en ce que** les lignes (60, 60', 60") de bit ont une hauteur de 0,1 µm à 0,3 µm.

5. Agencement de cellules de mémoire suivant l'une des revendications 1 à 4,
- dans lequel la nervure (30) a respectivement deux lignes de cellules de mémoire et
- dans lequel les cellules de mémoire voisines perpendiculaires à l'étendue des lignes (60) de bit ont une source (29) ou un drain commun.

6. Procédé de production d'un agencement de cellules de mémoire, dans lequel on ménage par attaque des sillons (20) isolants dans le substrat (10) semiconducteur, de manière à former des nervures (30) entre les sillons (20) isolants, et dans lequel on produit ensuite des lignes (60, 60', 60") de bit,
**caractérisé**
**en ce que**, avant de produire les lignes (60, 60', 60") de bit, on produit des zones de canal et en ce que, après la production des lignes (60, 60', 60") de bit, on effectue un stade d'attaque, par lequel les sillons (20) isolants pénètrent profondément dans le substrat (10) semiconducteur.

7. Procédé suivant la revendication 6,
**caractérisé**
**en ce qu'**on produit les lignes (60, 60', 60") de bit par implantation d'ions (35).

8. Procédé suivant l'une des revendications 6 ou 7,
**caractérisé**
**en ce qu'**on transforme les lignes (60, 60', 60") de bit en un composé métallique.

9. Procédé suivant la revendication 8,
**caractérisé**
**en ce qu'**on transforme les lignes (60, 60', 60") de bit en un composé métallique du silicium.
